# EUROPÄISCHE PATENTSCHRIFT

(11) **EP 2 791 975 B1**
(45) Veröffentlichungstag und Bekanntmachung des Hinweises auf die Patenterteilung: **14.11.2018**
(21) Anmeldenummer: 12769888.4
(22) Anmeldetag: 20.08.2012
(51) Int. Cl.: H01L 31/048, H01L 31/0224, H01L 31/05, H01L 31/18

(54) **VERFAHREN ZUM HERSTELLEN EINES HALBZEUGS FÜR EIN MODUL MIT EINER ZELLE AUS PHOTOAKTIVEM MATERIAL UND VORRICHTUNG ZUM HERSTELLEN DES HALBZEUGS**
METHOD FOR MANUFACTURING A SEMI-FINISHED PRODUCT FOR A MODULE HAVING A CELL MADE FROM A PHOTOACTIVE MATERIAL AND APPARATUS FOR THE MANUFACTURE OF THE SEMI-FINISHED PRODUCT
PROCÉDÉ POUR FABRIQUER UN DEMI-PRODUIT DESTINÉ À UN MODULE COMPORTANT UNE CELLULE EN MATÉRIAU PHOTO-ACTIF ET DISPOSITIF POUR LA FABRICATION DU DEMI-PRODUIT

(30) Priorität: 12.12.2011 DE 202011052268 U
(43) Veröffentlichungstag der Anmeldung: 22.10.2014
(73) Patentinhaber: Sitec Solar GmbH, 16816 Neuruppin (DE)
(72) Erfinder: ALBRECHT, Dirk, 16833 Fehrbellin (DE); SCHRAMM, Nico, 16816 Neuruppin (DE); BUSCHMANN, Heinz, 16816 Neuruppin (DE)
(74) Vertreter: Bittner, Thomas L.
(86) Internationale Anmeldenummer: PCT/DE2012/100243
(87) Internationale Veröffentlichungsnummer: WO 2013/087066

(56) Entgegenhaltungen:
- DE-A1-102010 003 765
- MARIO GONZALEZ ET AL: "Thermo-mechanical challenges of advanced solar cell modules", THERMAL, MECHANICAL AND MULTI-PHYSICS SIMULATION AND EXPERIMENTS IN MICROELECTRONICS AND MICROSYSTEMS (EUROSIME), 2011 12TH INTERNATIONAL CONFERENCE ON, IEEE, 18. April 2011 (2011-04-18), Seiten 1/7-7/7, XP031865520, DOI: 10.1109/ESIME.2011.5765822 ISBN: 978-1-4577-0107-8
- MARC KÖNTGES ET AL: "A Novel Photovoltaic-Module Assembly System for Back Contact Solar Cells Using Laser Soldering Technique", PROCEEDINGS OF THE 23RD EUROPEAN PHOTOVOLTAIC SOLAR ENERGY CONFERENCE, 1. September 2008 (2008-09-01), - 5. September 2008 (2008-09-05), Seiten 2709-2712, XP040529473, DOI: 10.4229/23rdEUPVSEC2008-4CO.1.5 ISBN: 978-3-936338-24-9
- GEE J M ET AL: "Simplified module assembly using back-contact crystalline-silicon solar cells", CONFERENCE RECORD OF THE 26TH IEEE PHOTOVOLTAIC SPECIALISTS CONFERENCE - 1997. PVSC '97. ANAHEIM, CA, SEPT. 29 - OCT. 3, 1997; [IEEE PHOTOVOLTAIC SPECIALISTS CONFERENCE], NEW YORK, NY : IEEE, US, 29. September 1997 (1997-09-29), Seiten 1085-1088, XP010268032, DOI: 10.1109/PVSC.1997.654276 ISBN: 978-0-7803-3767-1
- A. VAN DER HEIDE ET AL: "Industrial Fabrication of Multi-Crystalline MWT Cells with Interconnection Flexibility of 16.5% Efficiency", PROCEEDINGS OF THE 24TH EUROPEAN PHOTOVOLTAIC SOLAR ENERGY CONFERENCE, 21. September 2009 (2009-09-21), - 25. September 2009 (2009-09-25), Seiten 942-945, XP040529857, DOI: 10.4229/24thEUPVSEC2009-2AO.2.3 ISBN: 978-3-936338-25-6

## Beschreibung

Die Erfindung betrifft ein Verfahren zum Herstellen eines Halbzeugs für Modul mit einer Zelle aus photoaktivem Material. In einer beispielhaften Ausführungsform bezieht sich die Erfindung auf ein Halbzeug für ein Solarmodul mit einer oder mehreren Solarzellen. Weiterhin ist eine Vorrichtung zum Herstellen vorgesehen.

### Hintergrund

Derartige Halbzeuge dienen zur Herstellung von Modulen mit einer oder mehreren Zellen aus photoaktivem Material. Bei den Zellen handelt es sich beispielsweise um Solarzellen, also Zellen mit einem photoaktiven Material, welches Sonnenlicht absorbiert und in elektrische Energie wandelt. Andererseits können Zellen Verwendung finden, bei denen eine angelegte elektrische Energie in Lichtemission umgewandelt wird. Solche photoaktiven Materialien werden zum Beispiel in Form organischer Schichtstapel angewendet, mit denen sogenannte organische lichtemittierende Dioden gebildet sind.

Unabhängig von der konkreten Ausprägung der Zellen in dem Modul verfügen die Zellen üblicherweise über elektrische Anschlussleitungen, mit denen insbesondere ein elektrischer Kontakt zwischen Kontaktanschlüssen einerseits, über die die jeweilige Zelle mit einer äußeren Beschaltung verbunden wird, und dem photoaktiven Material der Zelle andererseits hergestellt wird.

Die an den Anschlussleitungen gebildeten Kontaktanschlüsse bedürfen besonderer Beachtung während der Modulherstellung. Ein Problem besteht hierbei insbesondere darin, dass die Kontaktanschlüsse im Rahmen des Auftrags der verschiedenen Schichten des Moduls zwischenzeitlich durch eine oder mehrere Schichten bedeckt werden, so dass sie anschließend, bevor eine Nutzung der Kontaktanschlüsse zur elektrischen Kontaktierung erfolgen kann, wieder freizulegen sind. Aus dem Dokument DE 10 2009 026 064 A1 ist ein Verfahren zum Freilegen eines elektrischen Kontaktes bekannt. Das Freilegen erfolgt bei dem vorgeschlagenen Verfahren indem mittels Laserlicht eine den Kontaktanschluss bedeckende Kunststoffschicht aufgeschnitten wird, nachdem zuvor mittels eines Sensors die Lage des elektrischen Kontaktanschlusses ermittelt wurde.

Das Dokument EP 2 113 945 A1 offenbart ein Verfahren zum Herstellen einer Kontaktierung von Solarzellen. Bei dem bekannten Verfahren erfolgt ein Freilegen des Kontaktanschlusses nach dem Auflaminieren einer Deckschicht, indem mindestens eine der die Solarzellen überdeckenden Schichten in dem gewünschten Bereich vollständig durchstoßen wird, insbesondere mittels Abtragen der auflaminierten Schicht. Die hierbei durchstoßene Schicht besteht beispielsweise aus einer Laminierfolie.

Aus dem Dokument EP 0 867 947 A2 ist ein Solarzellen-Modul bekannt.

Im Dokument WO 2011/133992 A2 sind ein Verfahren zum Kontaktieren eines photovoltai-schen Moduls mit einem Anschlussgehäuse sowie ein System bestehend aus einem photovoltaischen Modul und einem Anschlussgehäuse beschrieben.

In dem Dokument Gonzales et al ("Thermo-mechanical challenges of advanced solar cell modules" Thermal, Mechanical and multi-physics simulation and experiments in microelectronics and microsystems (EUROSIME), 2011 12TH International Conference, on, IEEE, 18 April 2011 (2011-04-18), pages 1/7-7/7) wird ein Verfahren zum Herstellen eines Solarzellen-Moduls beschrieben. Mehrere Solarzellen werden mit ihrer Lichteinfallseite auf einem Modulsubstrat abgelegt. Nach dem elektrischen Kontaktieren der Solarzellen wird ein Kapselungsmaterial aufgetragen. Das Kapselungsmaterial kann beim Auftragen mittels Drucken oder Photolithographie strukturiert werden. Um nachträglich Metallkontakte wieder freizulegen, ist das Bohren von Durchbrüchen durch das Kapselungsmaterial vorgesehen.

In ähnlicher Weise wird im Dokument DE 10 2010 003 765 A1 im Zusammenhang mit dem Herstellen eines Photovoltaik-Moduls mit rückseitenkontaktierten Halbleiterzellen vorgeschlagen, Kontaktanschlüsse nachträglich mittels Laserbohren wieder frei zu legen.

Das Herstellen eines Photovoltaik-Moduls ist weiterhin in den Dokumenten Köntges et al. ("A Novel Photovoltaic-Module Assembly System for Back Contact Solar Cells Using Laser Soldering Technique" Proceedings of the 23RD European Photovoltaic Solar Energy Conference, 1 September 2008 (2008-09-01), - 5 September 2008 (2008-09-05), pages 2709-2712) sowie Gee et al: ("Simplified module assembly using back-contact crystalline-silicon solar cells" Conference Record of the 26th IEEE Photovoltaic Specialists Conference - 1997. PVSC'97, ANAHEIM, CA, Sept, 29-Oct. 1997 [IEEE Photovoltaic Specialists Conference], New York, NY: IEEE, US, 29 September 1997 (1997-09-29), pages 1085-1088) beschrieben.

Auch das Dokument Van der Heide et al. ("Industrial Fabrication of Multi-Crystalline MWT Cells with Interconnection Flexibility of 16,5% Efficiency" Proceedings oft he 24th European Photovoltaic Solar Energy Conference, 21 September 2009 (2009-09-21), -25 September 2009 (2009-09-25), pages 942-945) betrifft das Herstellen eines Photovoltaik-Moduls mit mehreren Solarzellen, die miteinander kontaktiert werden.

### Zusammenfassung

Aufgabe der Erfindung ist es, verbesserte Technologien in Verbindung mit einem Halbzeug für ein Modul mit einer Zelle aus photoaktivem Material anzugeben, bei denen das Freilegen eines elektrischen Kontaktanschlusses auf einfache und effiziente Art und Weise ermöglicht ist, insbesondere auch nachträglich. Es soll allgemein eine Technologie bereitgestellt werden, die das Freilegen eines oder mehrerer elektrischer Kontaktanschlüsse im Rahmen der Modulherstellung von Modulen mit einer oder mehreren Zellen aus photoaktivem Material erleichtert.

Diese Aufgabe wird erfindungsgemäß durch ein Verfahren zum Herstellen eines Halbzeugs für ein Modul mit einer Zelle aus photoaktivem Material nach dem unabhängigen Anspruch 1 gelöst. Weiterhin ist eine Vorrichtung zum Bearbeiten eines Halbzeugs nach Anspruch 9 vorgesehen. Vorteilhafte Ausgestaltungen der Erfindung sind Gegenstand von abhängigen Unteransprüchen.

Bei dem Verfahren zum Herstellen eines Halbzeugs für ein Modul mit einer Zelle aus photoaktivem Material, bei der es sich beispielsweise um eine Solarzelle handelt, wird zunächst ein Substrat bereitgestellt. Hierbei kann es sich zum Beispiel um ein Glassubstrat handeln. Auf dem Substrat werden eine oder mehrere photoaktive Zellen angeordnet, derart, dass eine Lichteinfall- oder eine Lichtemissionsseite der Zelle dem Substrat zugewandt ist. Es wird eine Haftmassenschicht ausgebildet. Hierbei werden die Zelle und ein an einer Anschlussleitung der Zelle gebildeter Kontaktanschluss teilweise oder vollständig in das Material der Haftmassenschicht eingebettet. Beispielsweise wird das Haftmassenmaterial aufgestrichen, aufgerakelt oder aufgespritzt. Bei dem Herstellen des Halbzeugs wird eine rückseitige Deckschicht hergestellt, die zumindest mit der Haftmassenschicht haftend verbunden ist, sei es direkt oder über eine oder mehrere dazwischen liegende Schichten.

Um ein Halbzeug für einen weiteren Fertigungsprozess herzustellen, wird dann rückseitig in Bezug auf das Substrat ein Kontaktbereich mit dem hierin angeordneten Kontaktanschluss. Über den Kontaktbereich ist später eine Kontaktierung der Zelle an Anschlussleitungen ermöglicht, beispielsweise mittels Löten. Zum Ausbilden des Kontaktbereiches wird der Kontaktanschluss nachträglich wieder freigelegt, indem ein auf dem Kontaktanschluss angeordneter lösbarer Schichtverbund oder -aufbau entfernt wird, welcher auch nur einschichtig sein kann. Der lösbare Schichtverbund umfasst wenigstens das Material der Haftmassenschicht, welches oberhalb des Kontaktanschlusses in dem auszubildenden Kontaktbereich zuvor angeordnet wurde. Hierbei kann vorgesehen sein, Sollbruch- oder Sollreißstellen am zu lösenden Schichtaufbau auszubilden.

Zum Entfernen des Schichtverbundes wird die Haftung zwischen dem Kontaktanschluss und der oberhalb des Kontaktanschlusses angeordneten Haftmassenschicht gemindert. Hierzu kann einerseits vorgesehen sein, den Kontaktanschluss vor dem Aufbringen der Haftmassenschicht zumindest teilweise mit einem Abdeckelement zu bedecken, zum Beispiel zum Ausbilden einer Abdeckschicht. Erfindungsgemäß wird die Haftminderung hergestellt, indem der Kontaktanschluss und / oder wenigstens ein benachbart zum Kontaktanschluss angeordneter Bereich der Haftmassenschicht mit einer Aktivierungsenergie beaufschlagt werden. Hierbei erfolgt von außerhalb ein Energieeintrag, vorzugsweise mithilfe eines kontaktlosen Energieeintragverfahrens. Beispielsweise kann vorgesehen sein, Laserlicht einzustrahlen.

Alternativ oder ergänzend kann ein induktives Verfahren genutzt werden, um die Aktivierungsenergie einzutragen, insbesondere in den metallischen Kontaktanschluss. Hierfür kann es vorgesehen sein, dass eine außerhalb angeordnete Induktionsschleife mit dem Kontaktanschluss wechselwirkt, um die Aktivierungsenergie einzutragen. Zum Beispiel kann der Aktivierungsenergieeintrag dazu führen, dass sich der Kontaktanschluss und / oder hierzu benachbarte Bereiche der Haftmassenschicht erwärmen, wodurch die Haftung gemindert wird. Aber auch eine mechanische Kontaktminderung mithilfe der von außen eingetragenen Aktivierungsenergie kann vorgesehen sein.

Im Fall der Verfahrensgestaltung, bei der das Abdeckelement auf dem Kontaktanschluss genutzt wird, um die Haftung zwischen Kontaktanschluss und Haftmassenschicht zu mindern, kann die Abdeckschicht mithilfe verschiedener Verfahren auf dem Kontaktanschluss aufgetragen werden, wozu zum Beispiel das Aufkleben einer Abdeckschicht oder das Aufsprühen einer solchen Schicht gehören. Beim Entfernen des Schichtverbundes oberhalb des Kontaktanschlusses wird die Abdeckschicht vorzugsweise zusammen mit der Haftmassenschicht entfernt.

Es kann vorgesehen sein, dass eine rückseitige Deckschicht gebildet wird, die zumindest mit der Haftmassenschicht haftend verbunden wird.

Eine bevorzugte Weiterbildung sieht vor, dass zum Ausbilden des Kontaktbereiches in der rückseitigen Deckschicht ein dem auszubildenden Kontaktbereich zugeordneter Trennabschnitt hergestellt wird, entlang dem die rückseitige Deckschicht beim Entfernen des Schichtverbundes geöffnet wird. Der Trennabschnitt kann als Durchbruch und / oder Solltrenn- oder Sollbruchabschnitt in Form einer Materialschwächung oder -dünnung ausgebildet sein. Beispielsweise kann eine Lasertrennung oder -schwächung genutzt werden, um die rückseitige Deckschicht vorzubereiten, derart, dass beim Entfernen des lösbaren Schichtverbundes oder vorher die rückseitige Deckschicht geöffnet wird, sodass hierdurch der Schichtverbund entfernt werden kann.

Bei einer zweckmäßigen Ausgestaltung kann vorgesehen sein, dass die rückseitige Deckschicht mit einer dem auszubildenden Kontaktbereich zugeordneten und zuvor hergestellten Deckschichtöffnung aufgebracht wird. Durch die Deckschichtöffnung hindurch kann dann der Schichtverbund zum nachträglichen Freilegen des Kontaktanschlusses entfernt werden. Die Deckschichtöffnung kann beispielsweise als Stanzloch ausgeführt sein. Der auszubildende Kontaktbereich kann wenigstens teilweise mit der zugeordneten Deckschichtöffnung überlappen.

Eine vorteilhafte Ausführungsform sieht vor, dass beim Entfernen des Schichtverbundes eine Oberflächenschicht am Kontaktanschluss wenigstens teilweise entfernt wird. Zum Beispiel kann auf diese Weise eine Oxidschicht auf dem Kontaktanschluss entfernt werden.

Bevorzugt sieht eine Fortbildung vor, dass aufgrund des Beaufschlagens der Aktivierungsenergie ein Oberflächenbereich des Kontaktanschlusses und / oder ein zum Kontaktanschluss benachbarter Bereiche der Haftmassenschicht (10) erweichen, wahlweise bis hin zum Schmelzen. Das Erweichen oder Schmelzen von Material am Kontaktanschluss, insbesondere oberflächenseitig, kann das Ablösen einer hierauf gebildeten Oxidschicht erleichtern. Das Erweichen oder Schmelzen ist die Folge des Eintrags der Aktivierungsenergie, die bei dieser Ausführung zum Erwärmen im Bereich des Kontaktanschlusses und / oder benachbarter Bereiche der Haftmassenschicht führt.

Bei einer vorteilhaften Ausgestaltung kann vorgesehen sein, dass an dem Schichtverbund außenseitig ein Abziehelement angeordnet wird, mit dem der Schichtverbund zum nachträglichen Freilegen des Kontaktanschlusses entfernt werden kann. Das Abziehelement, welches beispielsweise mit einer Abziehschicht gebildet ist, kann den Zugriff auf den zu lösenden Schichtverbund beim Ausbilden des Kontaktbereiches erleichtern. Nach dem Greifen des Abziehelementes kann dieses per Hand oder maschinell zusammen mit dem Schichtverbund entfernt werden.

Nachfolgend werden weitere Ausführungen des Halbzeugs erläutert. Es kann vorgesehen sein, dass eine Abdeckschicht den Kontaktanschluss wenigstens teilweise abdeckt. Eine Weiterbildung sieht vor, dass die rückseitige Deckschicht eine dem auszubildenden Kontaktbereich zugeordnete Deckschichtöffnung aufweist. Bei einer Ausgestaltung kann vorgesehen sein, dass an dem Schichtverbund außenseitig ein Abziehelement angeordnet ist.

Eine vorteilhafte Ausführungsform sieht vor, dass die Abdeckschicht haftend auf dem Kontaktanschluss angeordnet ist und dass die Haftkraft zwischen der Haftmassenschicht und der Abdeckschicht größer als die Haftkraft zwischen der Abdeckschicht und dem Kontaktanschluss ist.

Eine Fortbildung sieht vor, dass der Kontaktbereich sich in mindestens einem der folgenden Abschnitte auf der Rückseite des Substrats erstreckt: seitlich zur Zelle und einer Zellenrückseite.

Nachfolgend werden weitere Ausführungen erläutert.

Mit dem vorgeschlagenen Halbzeug ist es ermöglicht, nachträglich den Kontaktanschluss, welcher insbesondere dem elektrischen Anschluss einer äußeren Beschaltung an die Zelle dient, im Verlauf der Modulfertigung nachträglich wieder freizulegen, nachdem der Kontaktanschluss zunächst beim Auflaminieren der Schichten der Schichtanordnung des Moduls überbedeckt wurde. Hierzu ist in einer Ausgestaltung ein lösbarer Schichtverbund vorgesehen, der im Bereich der dem Kontaktanschluss zugeordneten Öffnung der rückseitigen Deckschicht angeordnet ist. Nachdem also die Haftmassenschicht, in welche die Zelle eingebettet ist, sowie wahlweise die rückseitige Decksicht aufgetragen wurden, kann der Schichtverbund im Bereich der dem Kontaktanschluss zugeordneten Deckschichtöffnung abgezogen werden, insbesondere dadurch, dass an der Abziehschicht des lösbaren Schichtverbundes gezogen wird, um auf diese Weise den zunächst bedeckten Kontaktanschluss wieder freizulegen. Hierbei reißt die Haftmassenschicht in den Bereichen, die unterhalb des Randes der Deckschichtöffnung oder benachbart hierzu liegen. Der Schichtverbund mit Abdeckschicht, welche den Kontaktanschluss beim Auftragen der Haftmassenschicht zuvor geschützt hat, der Haftmassenschicht selbst sowie der hierauf gebildeten Abziehschicht wird entfernt. Anschließend steht der Kontaktanschluss zum elektrischen Anschließen einer äußeren Beschaltung zur Verfügung, wobei der elektrische Anschluss beispielsweise mittels Löten oder einer elektrisch leitenden Klebverbindung erfolgt. Insbesondere im all der Nutzung einer oder mehrer Solarzellen in einem Solarmodul kann so ein sogenannter Dosenanschlussbereich gebildet werden.

Innerhalb des im Bereich der Deckschichtöffnung gebildeten lösbaren Schichtverbundes erstreckt sich die Haftmassenschicht von unten wahlweise in die Deckschichtöffnung hinein und füllt diese dann teilweise oder im Wesentlichen vollständig aus. Dieses wenigstens teilweise Auffüllen der Deckschichtöffnung mit dem Material der Haftmassenschicht in einer Ausgestaltung erfolgt zum Beispiel beim Auftragen der Haftmassenschicht zusammen mit der rückseitigen Deckschicht. Unter Druckbeaufschlagung wird die rückseitige Deckschicht zusammen mit der Haftmassenschicht oder nachträglich rückseitig aufgetragen, zum Beispiel bei der Solarmodulherstellung, wodurch sich das Material der Haftmassenschicht auch in den Bereich der Deckschichtöffnung hinein bewegt.

Die Deckschichtöffnung ihrerseits kann auf der Seite der rückseitigen Deckschicht, welche von dem Substrat abgewandt ist, mittels der Abziehschicht in einer Ausführung so verschlossen, dass ein rückseitiges Austreten des Materials der Haftmassenschicht durch die Deckschichtöffnung vermieden ist. Vielmehr entsteht hierbei dann der Schichtverbund, in welchem die Abdeckschicht den Kontaktanschluss abdeckt und in dem die Abdeckschicht und die außen liegende Abziehschicht über die Haftmassenschicht und wahlweise weitere Zwischenschicht(en) haftend verbunden sind, derart, dass dieser Schichtverbund dann zum Freilegen des Kontaktanschlusses entfernt werden kann. Dieses Entfernen kann manuell oder mittels einer maschinellen Einrichtung erfolgen, zum Beispiel mittels eines maschinell betriebenen Greifers. Es kann vorgesehen sein, dass an der Abziehschicht eine Zieh- oder Grifflasche gebildet ist, die das (nachträgliche) Entfernen des lösbaren Schichtverbundes erleichtert.

Auf dem Substrat können auch mehrere Zellen aus photoaktivem Material angeordnet sein, zum Beispiel mehrere Solarzellen, die eine Solarzellenanordnung eines Solarmoduls bilden. Bei dieser Ausgestaltung mit mehreren Zellen kann der Kontaktbereich mit dem Kontaktanschluss dann wenigstens teilweise zwischen benachbarten Zellen gebildet sind. Sind die eine oder die mehreren Zellen aus photoaktivem Material als Solarzellen ausgeführt, kann es sich um Solarzellen mit vorder- und / oder rückseitiger Kontaktierung handeln. Auch können Solarzellen dieser unterschiedlichen Bauformen in einem Modul miteinander kombiniert werden. Im Fall von Zellen mit rückseitiger Kontaktierung kann der Kontaktbereich zumindest teilweise auf der Zelle selbst gebildet sein, nämlich auf deren vom Substrat abgewandten Rückseite.

Die Anschlussleitung, die endseitig im Kontaktbereich den Kontaktanschluss aufweist, kann in einer Ausgestaltung zum Beispiel als eine Leitungsbahn auf dem Substrat liegend gebildet sein. Eine Zelle kann mit mehreren derartigen Anschlussleitungen versehen sein, die jeweils endseitig einen Kontaktanschluss aufweisen, die im gleichen oder unterschiedlichen Kontaktbereichen angeordnet sind.

Verfügt das Halbzeug für das Modul über mehrere Kontaktbereiche, so sind mehrere oder alle dieser Kontaktbereiche in einer Ausgestaltung mit einem lösbaren Schichtverbund der oben beschriebenen Art in der zugeordneten Deckschichtöffnung versehen.

Die eine oder die mehrere Deckschichtöffhungen in der rückseitigen Deckschicht können zum Beispiel jeweils als ein Stanzloch ausgeführt sein. Auch ein Trennen mittels Laserschneiden kann vorgesehen sein.

Bei einer Ausgestaltung kann vorgesehen sein, dass die Abdeckschicht haftend auf dem Kontaktanschluss angeordnet ist und dass die Haftkraft zwischen der Haftmassenschicht und der Abdeckschicht größer als die Haftkraft zwischen der Abdeckschicht und dem Kontaktanschluss ist. Dieses unterstützt ein möglichst effizientes nachträgliches Entfernen des lösbaren Schichtverbundes zum Freilegen des Kontaktanschlusses. Die Ausbildung der entsprechenden Haftkräfte zwischen den benachbarten Schichten kann mittels des direkten Kontaktes zwischen den Schichten oder wahlweise unter Zwischenschaltung ein oder mehrerer Zwischenschichten erfolgen. Beispielsweise kann vorgesehen sein, die Haftkräfte innerhalb des lösbaren Schichtverbundes unter Nutzung haftverstärkender oder haftmindernder Schichten einzustellen. Es kann vorgesehen sein, dass die außen liegende Abziehschicht auf ihrer dem Substrat zugewandten Seite eine haftverstärkende Schicht aufweist, die dann in Kontakt mit dem Material der Haftmassenschicht ist. Alternativ oder ergänzend kann die Abdeckschicht, welche am Boden des lösbaren Schichtverbundes den Kontaktanschluss bedeckt, auf der dem Kontaktanschluss zugewandten Seite mit einer haftmindernden Schicht versehen sein, die eine Haftung der Abdeckschicht an dem Kontaktanschluss sicherstellt und andererseits diesen Haft- oder Klebekontakt jedoch minimiert, um das nachträgliche Entfernen des lösbaren Schichtverbundes zum Freilegen des Kontaktanschlusses zu unterstützen.

Eine Weiterbildung sieht vor, dass in dem Kontaktbereich mehrere Kontaktanschlüsse angeordnet sind, die elektrisch getrennt und die der Zelle und / oder einer weiteren Zelle aus einem photoaktiven Material zugeordnet sind, und dass der lösbare Schichtverbund konfiguriert ist, beim Lösen die mehreren Kontaktanschlüsse für eine elektrische Kontaktierung freizugeben. Bei dieser Ausgestaltung werden beim Entfernen des lösbaren Schichtverbundes mehrere Kontaktanschlüsse gemeinsam freigelegt, also in einem Schritt des Entfernens des Schichtverbundes in der Deckschichtöffnung. In einer Ausgestaltung kann vorgesehen sein, dass die mehreren Kontaktanschlüsse auf gegenüberliegenden Seiten des Kontaktbereiches angeordnet sind.

Bei einer Ausgestaltung kann vorgesehen sein, dass die Abziehschicht und die Haftmassenschicht und / oder die Haftmassenschicht und die Abdeckschicht in direktem Haftkontakt stehen. Bei dieser Ausgestaltung sind zwischen den jeweils beteiligten Schichten keine zusätzlichen haftvermittelnden Schichten, sei es zur Verstärkung oder zur Minderung der Haftwirkung, vorgesehen. Die Haftung beruht also ausschließlich auf der Haft- oder Klebewirkung, die von der Abdeckschicht, der Abziehschicht und der Haftmassenschicht entwickelt wird.

Eine Ausführungsform sieht vor, dass die Abdeckschicht im Kontaktbereich zusätzlich einen nicht vom Kontaktanschluss erfassten Bereich abdeckt. In einer Ausgestaltung haftet die Abdeckschicht hierbei direkt auf Substratbereichen benachbart zum Kontaktanschluss. Es kann in einer Ausgestaltung vorgesehen sein, dass die Abschnitte, in welchen die Abdeckschicht den eigentlichen Bereich des Kontaktanschlusses selbst überragt, den Kontaktanschluss ganz oder vollständig umgreifen oder umranden, wodurch ein optimierter Schutz des Kontaktanschlusses gegen das Eindringen von Schichtmaterial beim Auflaminieren der Modulschichten gebildet ist. Zweckmäßigerweise ist dann die Haftkraft zwischen dem Substrat und der Abdeckschicht geringer als die Haftkraft zwischen der Abdeckschicht und der Haftmassenschicht.

Bevorzugt sieht eine Fortbildung vor, dass die Abdeckschicht bei Blickrichtung von der Rückseite auf die Deckschicht in ihrer flächigen Ausdehnung auf den Bereich der Deckschichtöffnung begrenzt ist. Vorzugsweise kann hierbei vorgesehen sein, dass in Blickrichtung auf die rückseitige Deckschicht ein umlaufender Abstand zwischen dem äußeren Rand der Abdeckschicht und dem umlaufenden Rand der Deckschichtöffnung gebildet ist, wobei der umlaufende Abstand auch abschnittsweise unterbrochen sein kann.

Bei einer Ausgestaltung kann vorgesehen sein, dass die die Abziehschicht auf einer von dem Substrat abgewandten Seite der rückseitigen Deckschicht randseitig mit der Deckschicht überlappt. Hierdurch ist auf optimierte Weise verhindert, das Material, insbesondere das Material der Haftmassenschicht, beim Aufdrücken der rückseitigen Deckschicht aus der Deckschichtöffnung austritt.

Eine Weiterbildung kann vorsehen, dass die Abziehschicht mehrere Deckschichtöffhungen erfassend gebildet ist. Bei dieser Ausführungsform wirkt die Abziehschicht mit mehreren lösbaren Schichtverbünden zusammen, so dass diese beim Abziehen der Abziehschicht, sei es manuell oder mittels maschineller Bedienungseinrichtung, mehrere getrennt voneinander gebildete Kontaktbereiche mit jeweils einem oder mehreren hierin gebildeten Kontaktanschlüssen freigelegt werden.

Eine bevorzugte Weiterbildung sieht vor, dass die Haftmassenschicht aus einer ausgehärteten und ursprünglich in pastöser oder flüssiger Konsistenz aufgetragenen Haftmasse besteht. Als Haftmassen kann beispielsweise ein Kleber auf Basis wenigstens einer Substanz aus der folgenden Gruppe verwendet werden: Silikon, Acrylat, Polyolefin, Polyurethan und einem ähnlichen Plastisol.

Bei einer Ausgestaltung kann vorgesehen sein, dass die rückseitige Deckschicht aus einem Folien- oder einem Plattenmaterial gebildet ist. Sei es in der Folienausprägung oder in anderer Form kann die rückseitige Deckschicht zum Beispiel aus Ethylenvinylacetat (EVA) bestehen. Als Plattenmaterial kann zum Beispiel Glas zum Einsatz kommen. Hierdurch ist es ermöglicht, zum Beispiel ein doppelseitiges Glasmodul bereitzustellen.

Eine Ausführungsform sieht vor, dass die Abdeckschicht und / oder die Abziehschicht aus einem Klebeband gebildet sind. Im Fall der Abdeckschicht handelt es sich vorzugsweise um ein ein- oder beidseitig haftendes Klebeband. Die Abziehschicht ist vorzugsweise ein einseitig haftendes Klebeband, wobei die Haftschicht auf der dem Substrat zugewandeten Seite ausgebildet ist.

In einer Ausgestaltung kann vorgesehen sein, dass der Kontaktbereich in mindestens einem der folgenden Abschnitte auf der Rückseite des Substrats angeordnet ist: seitlich zur Zelle und einer Zellenrückseite. Die Ausbildung des Kontaktbereiches auf der Zellenrückseite kann insbesondere bei sogenannten Rückkontaktzellen (Backkontaktzellen) auf der rückseitigen Oberfläche der Zelle erfolgen.

Das vorangehend in verschiedenen Ausführungsformen beschriebene Halbzeug für ein Modul mit einer Zelle aus photoaktiven Material, insbesondere Solarzelle, kann mit Hilfe eines Verfahrens hergestellt werden, welches die folgenden Schritte aufweist: Bereitstellen eines Substrats, Anordnen einer Zelle aus photoaktivem Material auf dem Substrat, derart, dass eine Lichteinfalls- oder eine Lichtemissionsseite der Zelle dem Substrat zugewandt ist, Ausbilden einer Haftmassenschicht, die mit dem Substrat und der Zelle haftend verbunden und in die die Zelle eingebettet wird, Ausbilden einer rückseitigen Deckschicht, die zumindest mit der Haftmassenschicht haftend verbunden wird, und Ausbilden eines Kontaktbereiches, der auf der Rückseite des Substrats gebildet und in dem ein Kontaktanschluss einer mit der Zelle verbundenen Anschlussleitung angeordnet wird, wobei der Kontaktbereich wenigstens teilweise mit einer zugeordneten Deckschichtöffnung überlappend gebildet wird und wobei im Bereich der Deckschichtöffnung und diese wahlweise durchgreifend ein zum Freilegen des Kontaktanschlusses durch die Deckschichtöffnung hindurch lösbarer Schichtverbund gebildet wird, bei dem eine Abdeckschicht den Kontaktanschluss abdeckt und die Abdeckschicht sowie eine Abziehschicht mittels der Haftmassenschicht haftend verbunden sind. Auf diese Weise ist ein Verfahren zum Herstellen eines Moduls mit einer Zelle aus photoaktivem Material geschaffen, welches die vorgenannten Schritte umfasst. Ergänzend kann dann ein Schritt vorgesehen sein, wahlweise auch zeitlich versetzt zu den vorgenannten Schritten, bei dem der Kontaktanschluss freigelegt wird, indem der Schichtverbund gelöst wird.

### Beschreibung bevorzugter Ausführungsbeispiele

Im Folgenden werden weitere Ausgestaltungen anhand von bevorzugten Ausführungsbeispielen unter Bezugnahme auf Figuren einer Zeichnung näher erläutert. Hierbei zeigen:
Fig. 1 eine Anordnung für ein Modul mit Zellen aus photoaktivem Material, bei der mehrere Zellen auf einem Substrat angeordnet sind, im Querschnitt,
Fig. 2 eine schematische Darstellung der Anordnung aus Fig. 1, wobei in einem Kontaktbereich eine Abdeckschicht angeordnet ist, die Kontaktanschlüsse abdeckt,
Fig. 3 eine schematische Darstellung der Anordnung aus Fig. 2, wobei eine Haftmassenschicht sowie eine rückseitige Deckschicht auflaminiert sind,
Fig. 4 eine schematische Darstellung der Anordnung aus Fig. 3, wobei Kontaktanschlüsse nachträglich freigelegt sind,
Fig. 5 eine weitere Anordnung für ein Modul mit Zellen aus photoaktivem Material, bei der eine Zelle auf einem Substrat angeordnet sind, im Querschnitt, und
Fig. 6 eine schematische Darstellung der Anordnung aus Fig. 5, wobei Kontaktanschlüsse nachträglich freigelegt sind,
Fig. 7 eine erfindungsgemäße Anordnung für ein Modul mit Zellen aus photoaktivem Material, vergleichbar Fig. 1, bei der mehrere Zellen auf einem Substrat angeordnet sind, im Querschnitt,
Fig. 8 eine schematische Darstellung der erfindungsgemäßen Anordnung aus Fig. 7, wobei eine Haftmassenschicht sowie eine rückseitige Deckschicht aufgebracht sind,
Fig. 9 eine schematische Darstellung der erfindungsgemäßen Anordnung aus Fig. 8, wobei zum nachträglichen Freilegen von Kontaktanschlüssen zumindest die rückseitige Deckschicht durchtrennt oder geschwächt ist und ein Trennwerkzeug aufgesetzt ist, und
Fig. 10 eine schematische Darstellung der erfindungsgemäßen Anordnung auf Fig. 9, wobei die Kontaktanschlüsse nun wieder freigelegt sind.

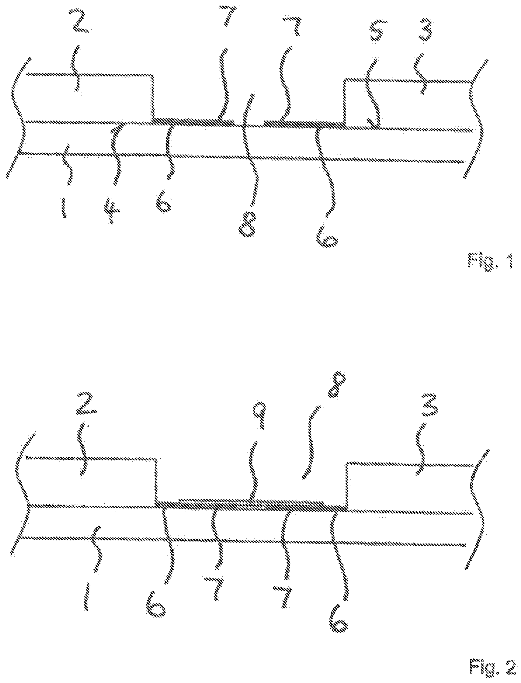

Im Folgenden wird auf die schematischen Darstellungen in den Fig. 1 bis 4 Bezug genommen, die eine Anordnung für ein Halbzeug für ein Modul mit Zellen aus photoaktivem Material während der Herstellung zeigen. In einer Ausgestaltung handelt es sich um eine Anordnung mit Solarzellen, die zur Solarmodulherstellung nutzbar ist. In einer anderen Ausgestaltung sind lichtemittierende Zellen vorgesehen, mit denen ein lichtemittierendes Modul herstellbar ist, zum Beispiel mit organischen lichtemittierenden Dioden.

Fig. 1 zeigt eine schematische Darstellung eines Abschnittes einer Anordnung im Querschnitt, bei der auf einem Substrat 1, bei dem es sich zum Beispiel um ein Glassubstrat handelt, rückseitig Zellen 2, 3 aus photoaktivem Material angeordnet sind. Eine Vorderseite 4 der Zellen 2, 3 ist in direktem Berührungskontakt mit einer Rückseite 5 des Substrats 1, ohne dass also eine Zwischenschicht hierzwischen gebildet ist. Im Fall von Solarzellen befindet sich auf der dem Substrat zugewandten Vorderseite 4 der Zellen 2, 3 die Lichteinfallsseite.

Zur elektrischen Kontaktierung der Zellen 2, 3, also insbesondere zum Anschluss einer äußeren Beschaltung (nicht dargestellt), ist jeweils eine Anschlussleitung 6 gebildet, die endseitig, also am zur Zelle 2, 3 distalen Ende, jeweils einen Kontaktanschluss 7 aufweist, der seinerseits in einem Kontaktbereich 8 angeordnet ist, der in der dargestellten Ausführungsform zwischen den Zellen 2, 3 gebildet ist. In anderen Ausgestaltungen (nicht dargestellt) kann der Kontaktbereich 8 auch randseitig, also außerhalb der Zellenanordnung gebildet sein. Auch können innerhalb und / oder außerhalb am Rand einer Zellenanordnung mehrere Kontaktbereiche mit jeweils einem oder mehreren Kontaktanschlüssen gebildet sein.

Fig. 2 zeigt eine schematische Darstellung der Anordnung aus Fig. 1, wobei nun die jeweiligen Kontaktanschlüsse 7 mit einer Abdeckschicht 9 bedeckt sind. Hierbei handelt es sich zum Beispiel um ein ein- oder ein beidseitiges Klebeband mit einem Haftmittel, welches eine rückstandsfreie Entfernung von den Kontaktanschlüssen 7 ermöglicht.

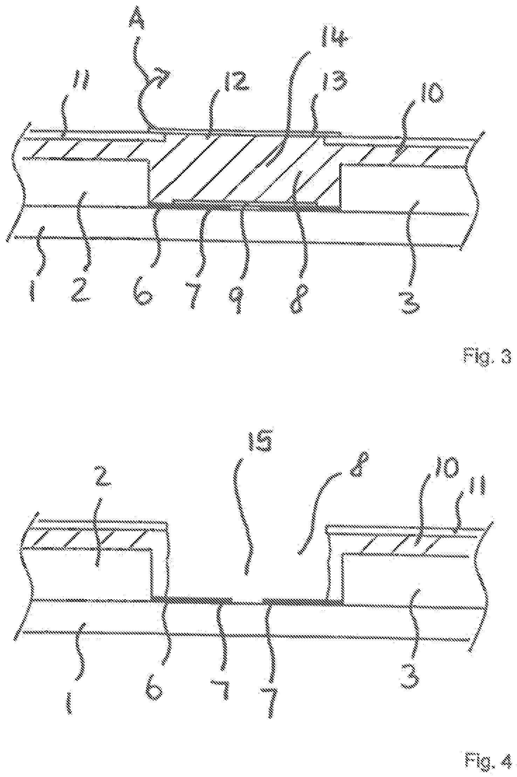

Fig. 3 zeigt eine schematische Darstellung der Anordnung aus Fig. 2, mit der nun ein Halbzeug mit den Zellen 2, 3 aus photoaktivem Material gebildet ist, bei dem eine Haftmassenschicht 10, in welche die Zellen 2, 3 eingebettet sind, sowie eine rückseitige Deckschicht 11 aufgetragen sind. Die rückseitige Deckschicht 11 weist überlappend mit dem Kontaktbereich 8 eine Deckschichtöffnung 12 auf, zum Beispiel in Form eines Stanzloches, in welche sich hinein das Material der Haftmassenschicht 10 erstreckt. Die Haftmassenschicht 10 besteht beispielsweise aus einem Klebematerial, welches zunächst in flüssiger oder pastöser Form aufgetragen wird, um anschließend auszuhärten. Das Auflaminieren der rückseitigen Deckschicht 11 kann gemeinsam mit der Auftragen des Materials für die Haftmassenschicht 10 erfolgen, oder anschließend. Hierfür sind verschiedene Verfahrensgestaltungen nutzbar, die als solche bekannt sind, zum Beispiel aus dem Dokument DE 10 2007 038 240 A1.

Gemäß Fig. 3 ist die Deckschichtöffnung 12 mit einer Abziehschicht 13 bedeckt, die im gezeigten Ausführungsbeispiel auf der rückseitigen Deckschicht 11 außen liegend und randseitig mit dieser überlappend angeordnet ist. Hierdurch ist ein Schichtverbund 14 gebildet, in welchem die Abdeckschicht 9 und die außen liegende Abziehschicht 13 über die hierzwischen angeordnete Haftmassenschicht 10 haftend verbunden sind. Dieser Schichtverbund 14 ist oberhalb der Kontaktanschlüsse 7 angeordnet und kann zu nachträglichen Freilegen der Kontaktanschlüsse 7 nun abgezogen werden, was in Fig. 3 mittels eines Pfeils A angedeutet ist.

Fig. 4 zeigt dann schematisch die Anordnung aus Fig. 3, wobei nun die Kontaktanschlüsse 7 freigelegt und für eine elektrische Kontaktierung der Zellen 2, 3 nutzbar sind. Der lösbare Schichtverbund 14 ist rückstandsfrei von den Kontaktanschlüssen 7 wieder entfernt, es ist eine Öffnung 15 im Kontaktbereich 8 gebildet, in welcher die Kontaktanschlüsse 7 freiliegen.

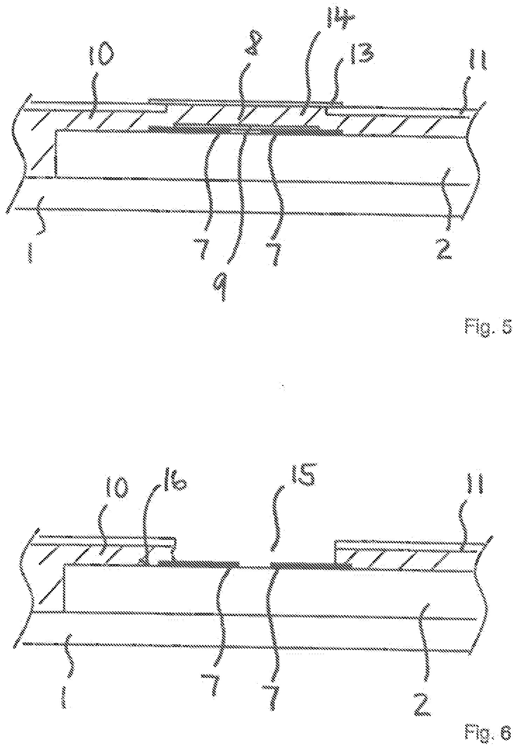

Fig. 5 und 6 zeigen eine weitere Anordnung für ein Modul mit Zellen aus photoaktivem Material, bei der eine Zelle auf einem Substrat angeordnet sind, im Querschnitt. Für gleiche Merkmale werden in den Fig. 5 und 6 die gleichen Bezugszeichen wie in den Fig. 1 bis 4 verwendet.

Fig. 5 zeigt eine schematische Darstellung eines Abschnittes einer Anordnung im Querschnitt, bei der auf dem Substrat 1 rückseitig eine Zelle 2 aus photoaktivem Material angeordnet ist. Im Unterschied zur Ausführung in Fig. 3 sind der Schichtverbund 14 wie auch die von diesem bedeckten Kontaktanschlüsse 7 auf einer Rückseite 16 der Zelle 2 angeordnet, die bei der dargestellten Ausführung als Zelle mit rückseitiger Kontaktierung (Backkontaktzelle) ausgeführt ist.

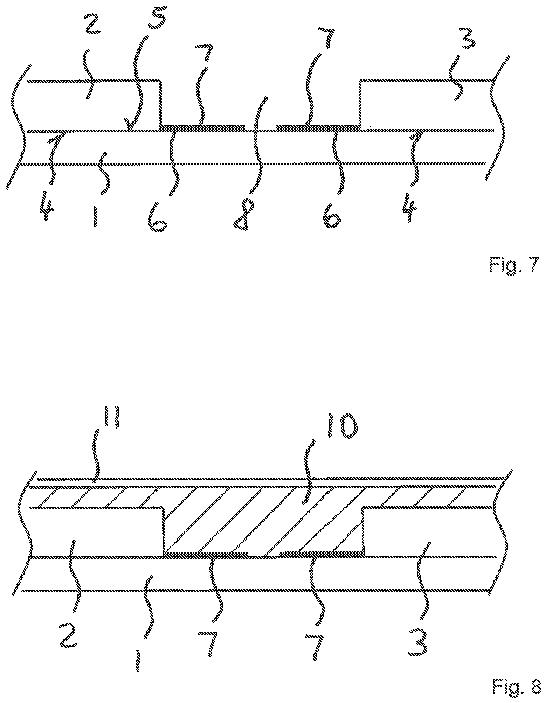

Im Folgenden wird unter Bezugnahme auf die Fig. 7 bis 10 eine erfindungsgemäße Ausführungsform für eine Anordnung für ein Halbzeug mit einem Modul mit Zellen aus photoaktiven Material erläutert. In einer Ausgestaltung handelt es sich um eine Anordnung von Solarzellen, die zur Solarmodulherstellung nutzbar sind. Eine weitere Ausgestaltung bezieht sich auf lichtemittierende Zellen, mit denen ein lichtemittierendes Modul herstellbar ist, zum Beispiel mit organischen lichtemittierenden Dioden.

Für gleiche Merkmale werden in den Fig. 7 bis 10 dieselben Bezugszeichen wie in den Fig. 1 bis 6 verwendet.

Fig. 7 zeigt eine schematische Darstellung eines Abschnittes einer Anordnung im Querschnitt, bei der auf einem Substrat 1, bei dem es sich zum Beispiel um ein Glassubstrat handelt, rückseitig Zellen 2, 3 aus photoaktivem Material angeordnet sind. Eine Vorderseite 4 der Zellen 2, 3 ist in direktem Berührungskontakt mit einer Rückseite 5 des Substrats 1, ohne dass also eine Zwischenschicht hierzwischen gebildet ist. Im Fall von Solarzellen befindet sich auf der dem Substrat 1 zugewandten Vorderseite 4 der Zellen 2, 3 die Lichteinfallsseite.

Zum elektrischen Kontaktieren der Zellen 2, 3, also insbesondere zum Anschluss einer äußeren Beschaltung (nicht dargestellt), ist jeweils eine Anschlussleitung 6 gebildet, die endseitig, also am zur Zelle 2, 3 distalen Ende, jeweils einen Kontaktanschluss 7 aufweist, der seinerseits in einem Kontaktbereich 8 angeordnet ist, der in der dargestellten Ausführungsform zwischen den Zellen 2, 3 gebildet ist. In anderen Ausgestaltungen (nicht dargestellt) kann der Kontaktbereich 8 auch randseitig, also außerhalb der Zellenanordnung gebildet sein. Auch können innerhalb und / oder außerhalb am Rand einer Zellenanordnung mehrere Kontaktbereiche mit jeweils einem oder mehreren Kontaktanschlüssen gebildet sein.

Fig. 8 zeigt eine schematische Darstellung der Anordnung aus Fig. 7, wobei nun die Kontaktanschlüsse 7 wie auch die Zellen 2, 3 aus photoaktivem Material mit einer Haftmassenschicht 10 bedeckt sind, derart, dass die Zellen 2, 3 eingebettet sind. Weiterhin ist eine rückseitige Deckschicht 11 aufgetragen. Im Unterschied zur Ausführung in den Fig. 1 bis 6 sind die Kontaktanschlüsse 7 nicht mit der Abdeckschicht 9 bedeckt. Vielmehr ist das Material der Haftmassenschicht 10 direkt auf die Kontaktanschlüsse 7 aufgetragen. Der Verfahrensschritt zum Ausbilden der Abdeckschicht 9 entfällt also. Auch ist die rückseitige Deckschicht 11 durchgehend gebildet, ohne dass sie (vgl. Fig. 3 oben) bei der gezeigten Ausgestaltung die Deckschichtöffnung 12 aufweist. Bei dieser Ausführung entfällt also ein Verfahrensschritt zum vorherigen Ausbilden der Deckschichtöffnung 12.

Vergleichbar der Ausführung in den Fig. 5 und 6 kann die in Fig. 8 gezeigte Ausgestaltung auch auf der Rückseite einer der Zellen 2, 3 hergestellt werden.

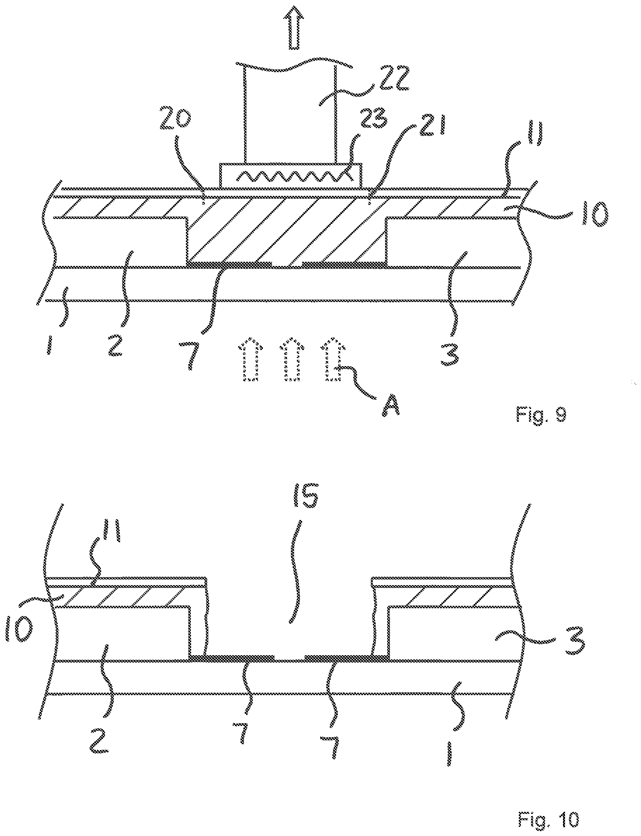

Um nun die Kontaktanschlüsse 7 nachträglich wieder freizulegen, wird zunächst gemäß Fig. 9 die rückseitige Deckschicht 11 im Bereich von Sollbruch- oder Sollreißstellen 20, 21 geschwächt oder wahlweise ganz durchbrochen. Hierzu kann beispielsweise ein Laserstrahl genutzt werden, um die rückseitige Deckschicht 11 in den gewünschten Bereichen zu durchtrennen oder zu schwächen. Das Ausmaß einer vorzugsweise umlaufend geschlossenen Durchtrennung oder Materialschwächung ist vergleichbar dem Ausmaß der Deckschichtöffnung 12 in den oben beschriebenen Ausgestaltungen. Wird die rückseitige Deckschicht 11 hierbei zumindest abschnittsweise vollständig durchtrennt, kann sich die so ausgebildete Materialtrennung bis in die darunter liegende Haftmassenschicht 10 erstrecken.

Im Folgenden wird nun eine Öffnung 15 in Kontaktbereich 8 gemäß Fig. 10 hergestellt. Hierzu wird gemäß Fig. 9 auf die Außenseite der rückseitigen Deckschicht 11 ein Trennwerkzeug 22 angesetzt, mit dem der Schichtverbund oberhalb der Kontaktanschlüsse 7 abgezogen wird. Die Haftung zwischen dem Trennwerkzeug 22 und der rückseitigen Deckschicht 11 kann auf verschiedene Weise hierbei hergestellt werden, beispielsweise dadurch, dass ein Haftmittel auf der rückseitigen Deckschicht 11 und / oder der zugewandten Oberfläche des Trennwerkzeuges 22 aufgetragen ist. Alternativ oder ergänzend kann im Bereich der dem Modus zugewandten vorderen Oberfläche des Trennwerkzeuges 22 ein Unterdruck bereitgestellt werden, beispielsweise dadurch, dass auf der dem Modul zugewandten Oberfläche Öffnungen angeordnet sind, die mit einem Unterdruck beaufschlagt werden. Mithilfe des Trennwerkzeuges 22 wird dann die in Fig. 10 gezeigte Öffnung 15 oberhalb der Kontaktanschlüsse 7 erzeugt.

Vor und / oder während des Abziehens des lösbaren Schichtverbundes beim nachträglichen Freilegen der Kontaktanschlüsse 7 wird die Haftwirkung zwischen den Kontaktanschlüssen 7 und der Haftmassenschicht 10 gemindert, um das nachträgliche Herauslösen mithilfe des Trennwerkzeuges 22 zu erleichtern. Die Haftminderung erfolgt bevorzugt dadurch, dass Energie in den Kontaktbereich zwischen den Kontaktanschlüssen 7 und der hierauf angeordneten Haftmassenschicht 10 eingebracht wird, beispielsweise in Form von Lichtenergie, Wärmeenergie und / oder elektromagnetischer Energien oder in anderer Form. Es kommt zum Beispiel zu einer Erwärmung der Kontaktanschlüsse 7, was die Haftung zum Material der Haftmassenschicht 10 mindert. Sind die Kontaktanschlüsse 7 mit einem Lotmaterial versehen, so kann es vorkommen, dass das Lotmaterial sich zumindest oberflächenseitig wenigstens teilweise verflüssigt, wodurch äußere Schichten beim Abziehen des hierauf angeordneten Materials der Haftmassenschicht 10 mit abgezogen werden. Hierdurch werden äußere Oxidschichten auf den Kontaktanschlüssen 7 mit entfernt, sodass deren störende Wirkung beim späteren Kontaktieren an den Kontaktanschlüssen 7 beseitigt wird.

Gemäß der schematischen Darstellung in Fig. 9 kann der Energieeintrag auf verschiedene Art und Weise erfolgen. In einer Ausgestaltung verfügt das Trennwerkzeug 22 selbst über eine Quelle 23 der in den Bereich des Kontaktes zwischen den Kontaktanschlüssen 7 und der Haftmassenschicht 10 einzubringenden Energie. Alternativ oder ergänzend kann der Kontaktbereich zur Minderung der Haftwirkung zwischen Kontaktanschlüssen 7 und Haftmassenschicht 10 auch durch das Substrat 1 hindurch mit Energie beaufschlagt werden (vgl. Pfeil A). Hier kann beispielsweise die Nutzung von Laserlicht vorgesehen sein. Im Zusammenhang mit der Verwendung der Quelle 23 am Trennwerkzeug 22 kann ein induktiver Energieeintrag vorgesehen sein. Aber auch die Nutzung einer Wärmeenergiequelle, beispielsweise einer Heizschleife, kann vorgesehen sein. Auch kann der Energieeintrag alternativ oder ergänzend durch die rückseitige Deckschicht 11 hindurch erfolgen, ohne dass die Energiequelle in dem Trennwerkzeug 22 selbst gebildet ist.

Bei den beschriebenen Ausführung ist die rückseitige Deckschicht 11 gebildet. Es kann in den verschiedenen Ausgestaltungen auch vorgesehen sein, das Herstellen des Kontaktbereiches 8 auszuführen, ohne dass die rückseitige Deckschicht 11 gebildet ist. In einem einfachen Fall wird hierbei dann nur die Haftmassenschicht 10 in dem gewünschten Bereich entfernt. Hierbei kann vorgesehen sein, diese, den Sollbruch- oder Sollreißstellen 20, 21 in Fig. 9 vergleichbar, für die Entfernung der Haftmassenschicht 10 vorzubereiten, zum Beispiel mittels Anritzen.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungen von Bedeutung sein.

## Patentansprüche

1. Verfahren zum Herstellen eines Halbzeugs für ein Modul mit einer Zelle aus photoaktivem Material, wobei das Verfahren die folgenden Schritte aufweist:
- Bereitstellen eines Substrats (1),
- Anordnen einer Zelle (2; 3) aus photoaktivem Material auf dem Substrat (1), derart, dass eine Lichteinfall- oder eine Lichtemissionsseite der Zelle (2; 3) dem Substrat (1) zugewandt ist,
- Ausbilden einer Haftmassenschicht (10), in die die Zelle (2; 3) und ein an einer Anschlussleitung der Zelle (2; 3) gebildeter Kontaktanschluss (7) teilweise oder vollständig eingebettet werden, und
- Ausbilden eines Kontaktbereiches (8), der auf der Rückseite des Substrats (1) mit dem hierin angeordneten Kontaktanschluss (7) gebildet wird, wobei zum Ausbilden des Kontaktbereiches (8) der Kontaktanschluss (7) nachträglich wieder freigelegt wird, indem ein auf dem Kontaktanschluss (7) angeordneter Schichtverbund (10, 11), der wenigstens das Material der Haftmassenschicht (10) umfasst, entfernt wird, **dadurch gekennzeichnet, dass** zum Entfernen des Schichtverbundes (10, 11)
- eine Haftung zwischen dem Kontaktanschluss (7) und der oberhalb des Kontaktanschlusses (7) angeordneten Haftmassenschicht (10) gemindert wird, indem der Kontaktanschluss (7) und / oder wenigstens ein benachbart zum Kontaktanschluss (7) angeordneter Bereich der Haftmassenschicht (10) mit einer Aktivierungsenergie beaufschlagt werden, die in den Kontaktbereich zwischen den Kontaktanschluss (7) und der Haftmassenschicht (10) eingebracht wird,
- ein Trennwerkzeug (22) auf den Schichtverbund (10, 11) angesetzt und eine Haftung zwischen dem Trennwerkzeug (22) und dem Schichtverbund (10, 11) ausgebildet wird und
- der Schichtverbund (10, 11) mittels des Trennwerkzeuges (22) abgezogen wird.

2. Verfahren nach Anspruch 1, **dadurch gekennzeichnet, dass** eine rückseitige Deckschicht (11) gebildet wird, die zumindest mit der Haftmassenschicht (10) haftend verbunden wird.

3. Verfahren nach Anspruch 2, **dadurch gekennzeichnet, dass** zum Ausbilden des Kontaktbereiches (8) in der rückseitigen Deckschicht (11) ein dem auszubildenden Kontaktbereich (8) zugeordneter Trennabschnitt hergestellt wird, entlang dem die rückseitige Deckschicht (11) beim Entfernen des Schichtverbundes (10, 11) geöffnet wird.

4. Verfahren nach Anspruch 2 oder 3, **dadurch gekennzeichnet, dass** die rückseitige Deckschicht (11) mit einer dem auszubildenden Kontaktbereich (8) zugeordneten und zuvor hergestellten Deckschichtöffnung (12) aufgebracht wird.

5. Verfahren nach mindestens einem der vorangehenden Ansprüche, **dadurch gekennzeichnet, dass** beim Entfernen des Schichtverbundes eine Oberflächenschicht am Kontaktanschluss (7) wenigstens teilweise entfernt wird.

6. Verfahren nach mindestens einem der vorangehenden Ansprüche, **dadurch gekennzeichnet, dass** aufgrund des Beaufschlagens der Aktivierungsenergie ein Oberflächenbereich des Kontaktanschlusses (7) und / oder ein zum Kontaktanschluss (7) benachbarter Bereiche der Haftmassenschicht (10) erweichen.

7. Verfahren nach mindestens einem der vorangehenden Ansprüche, **dadurch gekennzeichnet, dass** die Aktivierungsenergie mittels einer Energieeintragseinrichtung an dem Trennwerkzeug (22) bereitgestellt wird.

8. Verfahren nach mindestens einem der vorangehenden Ansprüche, **dadurch gekennzeichnet, dass**
- der Kontaktanschluss (7) mit einem Lotmaterial versehen ist,
- das Lotmaterial sich aufgrund des Eintragens der Aktivierungsenergie zumindest oberflächenseitig wenigstens teilweise verflüssigt und
- beim Abziehen des Schichtverbundes (10, 11) äußere Schichten mit abgezogen werden.

9. Vorrichtung zum Bearbeiten eines Halbzeuges für ein Modul mit einer Zelle aus photoaktivem Material, mit:
- einem Werkstückaufnehmer zum Aufnehmen eines Halbzeuges mit einer Schichtanordnung für ein Modul mit einer Zelle aus photoaktivem Material, die Schichtanordnung aufweisend:
- ein Substrat (1),
- eine Zelle (2; 3) aus photoaktivem Material auf dem Substrat (1), derart, dass eine Lichteinfall- oder eine Lichtemissionsseite (4) der Zelle (2; 3) dem Substrat (1) zugewandt ist, und
- eine Haftmassenschicht (10), in die die Zelle (2; 3) und ein an einer Anschlussleitung (6) der Zelle (2; 3) gebildeter Kontaktanschluss (7) teilweise oder vollständig eingebettet sind,
- einer Energieeintragseinrichtung, die konfiguriert ist, beim Bearbeiten des Halbzeuges eine Aktivierungsenergie bereitzustellen und zum Entfernen eines lösbaren Schichtverbundes (10, 11), der mindestens das Material der Haftmassenschicht (10) umfasst, den Kontaktanschluss (7) und / oder wenigstens einen benachbart zum Kontaktanschluss (7) angeordneten Bereich der Haftmassenschicht (10) mit der Aktivierungsenergie zu beaufschlagen, um eine Haftung zwischen dem Kontaktanschluss (7) und der oberhalb des Kontaktanschlusses (7) angeordneten Haftmassenschicht (10) zu mindern, und
- einem Trennwerkzeug (22), das geeignet ist, zum Ausbilden eines Kontaktbereiches (8) mit dem hierin angeordneten Kontaktanschlusses (7) auf der Rückseite (5) des Substrats (1) des Halbzeuges den lösbaren Schichtverbund (10, 11) zu entfernen, so dass der Kontaktanschluss (7) im Kontaktbereich (8) nachträglich freigelegt wird.

10. Vorrichtung nach Anspruch 9, **dadurch gekennzeichnet, dass** die Energieeintragseinrichtung an dem Trennwerkzeug (22) angeordnet ist.

## Claims

1. A method for manufacturing a semi-finished product for a module having a cell made from a photoactive material, wherein the method comprises the following steps:
- providing a substrate (1),
- arranging a cell (2; 3) made from a photoactive material on the substrate (1) in such a manner that a light-incidence or a light-emission side of the cell (2; 3) faces the substrate (1),
- constructing an adhesive-compound layer (10), into which the cell (2; 3) and a contact connector (7) formed on a connecting lead of the cell (2; 3) are partially or completely embedded, and
- constructing a contact region (8), which is formed on the rear side of the substrate (1) with the contact connector (7) formed herein, wherein the contact connector (7) is subsequently exposed again to construct the contact region (8), by a layer composite (10, 11) comprising at least the material of the adhesive-compound layer (10) and arranged on the contact connector (7) being removed,
**characterised in that**, to remove the layer composite (10, 11),
- an adhesion between the contact connector (7) and the adhesive-compound layer (10) arranged above the contact connector (7) is diminished by the contact connector (7) and/or at least one region of the adhesive-compound layer (10) arranged next to the contact connector (7) being loaded with an activation energy which is introduced into the contact region between the contact connector (7) and the adhesive-compound layer (10),
- a separating tool (22) is arranged onto the layer composite (10, 11) and an adhesion is formed between the separating tool (22) and the layer composite (10, 11) and
- the layer composite (10, 11) is pulled off by means of the separating tool (22).

2. The method according to claim 1, **characterised in that** a rear-side cover layer (11) is formed, which is adhesively connected at least to the adhesive-compound layer (10).

3. The method according to claim 2, **characterised in that**, to construct the contact region (8) in the rear-side cover layer (11), a separating section assigned to the contact region (8) to be constructed is produced, along which separating section, the rear-side cover layer (11) is opened when removing the layer composite (10, 11).

4. The method according to claim 2 or 3, **characterised in that** the rear-side cover layer (11) is applied using a cover layer opening (12), which is assigned to the contact region (8) to be constructed and is previously produced.

5. The method according to at least one of the preceding claims, **characterised in that** a surface layer on the contact connector (7) is at least partially removed when removing the layer composite.

6. The method according to at least one of the preceding claims, **characterised in that**, owing to the loading of the activation energy, a surface region of the contact connector (7) and / or a region of the adhesive-compound layer (10) adjacent to the contact connector (7) soften.

7. The method according to at least one of the preceding claims, **characterised in that** the activation energy is provided by means of an energy-input apparatus at the separating tool (22).

8. The method according to at least one of the preceding claims, **characterised in that**
- the contact connector (7) is provided with a soldering material,
- the soldering material is at least partially liquefied at least on a surface side due to the input of the activation energy and
- outer layers are also pulled off when the layer composite (10, 11) is pulled off.

9. A device for processing a semi-finished product for a module having a cell made from a photoactive material, having:
- a workpiece mounting for mounting a semi-finished product with a layer composite for a module with a cell made from a photoactive material, comprising:
- a substrate (1),
- a cell (2; 3) made from a photoactive material on the substrate (1) in such a manner that a light-incidence or a light-emission side of the cell (2; 3) faces the substrate (1), and
- an adhesive-compound layer (10), into which the cell (2; 3) and a contact connector (7) formed on a connecting lead (6) of the cell (2; 3) are partially or completely embedded,
- an energy-input apparatus, which is configured when processing the semi-finished product to provide an activation energy and, for removing a layer composite (10, 11) comprising at least the material of the adhesive-compound layer (10), to load the contact connector (7) and/or at least one region of the adhesive-compound layer (10) arranged adjacently to the contact connector (7) with the activation energy, in order to diminish an adhesion between the contact connector (7) and the adhesive-compound layer (10) arranged above the contact connector (7), and
- a separating tool (22), which is suitable for removing the detachable layer composite (10, 11) for constructing a contact region (8) having the contact connector (7) arranged herein on the rear side (5) of the substrate (1) of the semi-finished product, so that the contact connector (7) in the contact region (8) is subsequently exposed.

10. The device according to claim 9, **characterised in that** the energy-input apparatus is arranged on the separating tool (22).

## Revendications

1. Procédé de fabrication d'un produit semi-fini pour un module avec une cellule en matière photoactive, le procédé comportant les étapes suivantes :
- préparation d'un substrat (1),
- mise en place sur le substrat (1) d'une cellule (2 ; 3) composée d'une matière photoactive de telle manière qu'un côté d'incidence de la lumière ou d'émission de lumière de la cellule (2 ; 3) est tourné vers le substrat (1),
- constitution d'une couche de matière adhésive (10) dans laquelle la cellule (2 ; 3) et une borne de contact (7) formée sur un câble de connexion de la cellule (2 ; 3) sont en partie ou complètement encastrés, et
- constitution d'une zone de contact (8), qui est formée sur l'arrière du substrat (1) avec la borne de contact (7) disposée dedans, la borne de contact (7) étant à nouveau ultérieurement libérée pour former la zone de contact (8) dans laquelle un composite de couche (10, 11) disposé sur la borne de contact (7), comprenant au moins la matière de la couche de matière adhésive (10), est enlevé,
**caractérisé en ce que**
pour enlever le composite de couche (10, 11)
- une adhérence entre la borne de contact (7) et la couche de matière adhésive (10) disposée au-dessus de la borne de contact (7) est réduite, la borne de contact (7) et/ou au moins une zone de la couche de matière adhésive (10) disposée adjacente à la borne de contact (7) étant sollicité avec une énergie d'activation qui est introduite dans la zone de contact entre la borne de contact (7) et la couche de matière adhésive (10),
- un outil de séparation (22) mis en place sur le composite de couche (10, 11) et une adhérence est constituée entre l'outil de séparation (22) et le composite de couche (10,11), et
- le composite de couche (10, 11) est retiré au moyen de l'outil de séparation (22).

2. Procédé selon la revendication 1, **caractérisé en ce qu'**une couche de couverture arrière (11) est formée qui est reliée de manière adhésive au moins à la couche de matière adhésive (10).

3. Procédé selon la revendication 2, **caractérisé en ce que** pour constituer la zone de contact (8) dans la couche de couverture arrière (11), une section de séparation attribuée à la zone de contact à constituer (8) est fabriquée le long de laquelle la couche de couverture arrière (11) est ouverte lors de l'enlèvement du composite de couche (10, 11).

4. Procédé selon la revendication 2 ou 3, **caractérisé en ce que** la couche de couverture arrière (11) est appliquée avec une ouverture de couche de couverture (12) attribuée à la zone de contact à constituer (8) et fabriquée auparavant.

5. Procédé selon au moins l'une quelconque des revendications précédentes, **caractérisé en ce qu'**à l'enlèvement du composite de couche, une couche superficielle est enlevée au moins en partie sur la borne de contact (7).

6. Procédé selon au moins l'une quelconque des revendications précédentes, **caractérisé en ce qu'**en raison de la sollicitation de l'énergie d'activation, une zone de surface de la borne de contact (7) et/ou une des zones de la couche de matière adhésive (10) adjacentes à la borne de contact (7) fléchissent.

7. Procédé selon au moins l'une quelconque des revendications précédentes, **caractérisé en ce que** l'énergie d'activation est fournie à l'outil de séparation (22) au moyen d'un système d'apport en énergie.

8. Procédé selon au moins l'une quelconque des revendications précédentes, **caractérisé en ce que**
- la borne de contact (7) est dotée d'une matière de brasage,
- la matière de brasage se liquéfie au moins en partie au moins en surface en raison de l'apport d'énergie d'activation et
- les couches extérieures sont retirées lors de l'enlèvement du composite de couche (10, 11).

9. Dispositif pour le traitement d'un produit semi-fini pour un module avec une cellule en matière photoactive, avec :
- un porte-pièce pour loger un produit semi-fini avec un agencement de couche pour un module avec une cellule en matière photoactive, l'agencement de couche comportant :
- un substrat (1),
- une cellule (2 ; 3) en matière photoactive sur le substrat (1), de telle manière qu'un côté d'incidence de lumière ou d'émission de lumière (4) de la cellule (2 ; 3) est tourné vers le substrat (1), et
- une couche de matière adhésive (10), dans laquelle la cellule (2 ; 3) et un raccord de contact (7) formé sur un câble de connexion (6) de la cellule (2 ; 3) sont en partie ou complètement encastrés,
- un système d'apport d'énergie, qui est configuré pour fournir une énergie d'activation lors du traitement du produit semi-fini et pour enlever un composite de couche détachable (10, 11), qui comprend au moins la matière de la couche de matière adhésive (10), pour solliciter la borne de contact (7) et/ou au moins une zone de la couche de matière adhésive (10) disposée adjacente à la borne de contact (7) avec l'énergie d'activation pour réduire une adhérence entre la borne de contact (7) et la couche de matière adhésive (10) disposée au-dessus de la borne de contact (7), et
- un outil de séparation (22) qui est adapté pour enlever le composite de couche détachable (10, 11) pour constituer une zone de contact (8) avec la borne de contact (7) disposé dedans sur l'arrière (5) du substrat (1) du produit semi-fini de telle manière que la borne de contact (7) est ultérieurement libérée dans la zone de contact (8).

10. Dispositif selon la revendication 9, **caractérisé en ce que** le système d'apport en énergie est disposé sur l'outil de séparation (22).
